# EUROPÄISCHE PATENTSCHRIFT

(11) **EP 2 079 815 B1**
(45) Veröffentlichungstag und Bekanntmachung des Hinweises auf die Patenterteilung: **15.09.2010**
(21) Anmeldenummer: 07820503.6
(22) Anmeldetag: 24.09.2007
(51) Int. Cl.: C09J 7/00

(54) **HITZEAKTIVIERBARES KLEBEBAND INSBESONDERE FÜR DIE VERKLEBUNG VON ELEKTRONISCHEN BAUTEILEN UND LEITERBAHNEN**
HEAT-ACTIVABLE ADHESIVE TAPE PARTICULARLY FOR BONDING ELECTRONIC COMPONENTS AND CONDUCTOR TRACKS
RUBAN ADHESIF ACTIVABLE THERMIQUEMENT, EN PARTICULIER POUR LE COLLAGE DE COMPOSANTS ELECTRONIQUES ET DE PISTES CONDUCTRICES

(30) Priorität: 06.10.2006 DE 102006047738
(43) Veröffentlichungstag der Anmeldung: 22.07.2009
(73) Patentinhaber: TESA SE, 20253 Hamburg (DE)
(72) Erfinder: KRAWINKEL, Thorsten, 22457 Hamburg (DE)
(86) Internationale Anmeldenummer: PCT/EP2007/060096
(87) Internationale Veröffentlichungsnummer: WO 2008/043660

(56) Entgegenhaltungen:
- EP-A- 1 612 251
- EP-A- 1 612 253
- EP-A- 1 614 734
- WO-A-2004/074386
- WO-A-2007/025007
- US-A1- 2004 159 969

## Beschreibung

Die Erfindung betrifft eine hitzeaktivierbare Klebmasse mit geringem Fließvermögen bei hohen Temperaturen insbesondere zur Verklebung von flexiblen gedruckten Leiterbahnen (Flexible Printed Circuit Boards, FPCBs).

Flexible Printed Circuit Boards werden heutzutage in einer Vielzahl von elektronischen Geräten wie Handys, Radios, Computern, Druckern und vielen anderen eingesetzt. Sie sind aufgebaut aus Schichten von Kupfer und einem hochschmelzenden widerstandsfähigen Thermoplasten, meistens Polyimid, seltener Polyester. Für die Herstellung dieser FPCBs werden häufig Klebebänder mit besonders hohen Ansprüchen eingesetzt. Zum einen werden zur Herstellung der FPCBs die Kupferfolien mit den Polyimidfolien verklebt, zum anderen werden auch einzelne FPCBs miteinander verklebt, in diesem Fall findet eine Verklebung von Polyimid auf Polyimid statt. Daneben werden die FPCBs auch auf andere Substrate geklebt.

An die Klebebänder, die für diese Verklebungen eingesetzt werden, werden sehr hohe Ansprüche gestellt. Da sehr hohe Verklebungsleistungen erreicht werden müssen, werden im Allgemeinen hitzeaktivierbare Klebebänder eingesetzt, die bei hohen Temperaturen verarbeitet werden. Diese Klebebänder dürfen während dieser hohen Temperaturbelastung bei der Verklebung der FPCBs, die häufig bei Temperaturen um 200 °C stattfindet, keine flüchtigen Bestandteile abgeben. Um eine hohe Kohäsion zu erreichen, sollten die Klebebänder während dieser Temperaturbelastung vernetzen. Hohe Drücke während des Verklebungsprozesses machen es nötig, dass die Klebebänder bei hohen Temperaturen nur eine geringe Fließfähigkeit besitzen. Dieses wird durch hohe Viskosität des unvernetzten Klebebandes oder durch eine sehr schnelle Vernetzung erreicht. Zudem müssen die Klebebänder noch lötbadbeständig sein, das heißt, für eine kurze Zeit eine Temperaturbelastung von 288 °C überstehen.

Aus diesem Grund ist der Einsatz von reinen Thermoplasten nicht sinnvoll, obwohl diese sehr leicht aufschmelzen, für eine gute Benetzung der zu verklebenden Substrate sorgen und zu einer sehr schnellen Verklebung innerhalb von wenigen Sekunden führen. Andererseits sind diese bei hohen Temperaturen so weich, dass sie bei Verklebung unter Druck zum Herausquellen aus der Klebfuge neigen. Damit ist auch keine Lötbadbeständigkeit gegeben.

Üblicherweise werden für vernetzbare Klebebänder Epoxidharze oder Phenolharze eingesetzt, die mit bestimmten Härtern zu polymeren Netzwerken reagieren. In diesem speziellen Fall sind die Phenolharze nicht einsetzbar, da sie bei der Vernetzung Abspaltprodukte erzeugen, die freigesetzt werden und während der Aushärtung oder spätestens im Lötbad zu einer Blasenbildung führen.

Epoxidharze werden hauptsächlich in der Konstruktionsverklebung eingesetzt und ergeben nach der Aushärtung mit entsprechenden Vernetzern sehr spröde Klebmassen, die zwar hohe Klebfestigkeiten erreichen, aber kaum flexibel sind.

Eine Steigerung der Flexibilität ist für den Einsatz in FPCBs unumgänglich. Zum einen soll die Verklebung mit Hilfe eines Klebebandes geschehen, das idealerweise auf eine Rolle gewickelt ist, zum anderen handelt es sich um flexible Leiterbahnen, die auch gebogen werden müssen, gut zu erkennen am Beispiel der Leiterbahnen in einem Laptop, bei dem der aufklappbare Bildschirm über FPCBs mit den weiteren Schaltungen verbunden ist.

Eine Flexibilisierung dieser Epoxidharzkleber ist auf zwei Arten möglich. Zum einen existieren mit Elastomerketten flexibilisierte Epoxidharze, die aber durch die sehr kurzen Elastomerketten nur eine begrenzte Flexibilisierung erfahren. Die andere Möglichkeit ist, die Flexibilisierung durch die Zugabe von Elastomeren zu erreichen, die der Klebmasse zugegeben werden. Diese Variante hat den Nachteil, dass die Elastomere chemisch nicht vernetzt werden, wodurch nur solche Elastomere zum Einsatz kommen können, die bei hohen Temperaturen immer noch eine hohe Viskosität aufweisen.

Da die Klebebänder meistens aus Lösung hergestellt werden, ist es häufig schwierig, Elastomere zu finden, die langkettig genug sind, um bei hohen Temperaturen nicht zu fließen, andererseits aber noch so kurzkettig sind, dass sie in Lösung gebracht werden können.

Eine Herstellung über einen Hotmelt-Prozess ist bei vernetzenden Systemen nur sehr schwierig möglich, da eine frühzeitige Vernetzung während des Herstellprozesses vermieden werden muss.

Bei vielen Anwendungen im Bereich der Herstellung und Verarbeitung von FPCBs werden die Klebebänder von dem Trennmedium, das die Klebebänder normalerweise schützt, abgezogen und dann auf die zu verklebenden Untergründe positioniert. Dabei muss gewährleistet sein, dass die Klebebänder, die vor diesem Prozess häufig schon gestanzt wurden, während des Abziehens des Trennmediums und auch während der Positionierung nicht verformt werden. Da zum Abziehen des Trennmediums eine gewisse Kraft aufgewendet werden muss, muss der E-Modul der Klebebänder hoch genug sein, um durch diese Kraft keine Verdehnung oder sonstige Verformung zu erfahren. Da möglichst dünne Produkte eingesetzt werden sollen, ist es nur schwierig möglich, einen Träger in das Klebeband einzubauen, stattdessen besteht das Klebeband im Allgemeinen nur aus einer Klebmasseschicht. Diese Klebmasse muss also einen genügend hohen E-Modul besitzen, um nicht verdehnt zu werden.

Klebmassen auf Basis von säureanhydridmodifizierten Blockcopolymeren und Epoxidharzen sind bekannt aus der US 5,369,167 A. Beschrieben wird eine Herstellungsmethode dieser Compounds. Es werden zudem Härter eingesetzt für die Vernetzung des Epoxidharzes. Ein Klebeband wird nicht erwähnt.

Ähnliche Klebmassen sind auch in der JP 57/149369 A1 beschrieben. Wieder wird ein Härter für das Epoxidharz benötigt. Ein Klebeband ist nicht offenbart.

Eine Vernetzung von maleinsäureanhydridmodifizierten Blockcopolymeren mit Chelaten ist bekannt aus EP 1 311 559 A2, bei der eine Steigerung der Kohäsion der Blockcopolymermischungen beschrieben wird. Eine Möglichkeit, hitzeaktivierbare Klebebänder herzustellen, die trotz der Chelatvernetzung bei hohen Temperaturen eine Vernetzung mit Epoxidharzen eingehen, ist nicht erwähnt.

Weiterhin sind Chelatvemetzungen mit zum Beispiel säuremodifizierten Acrylatklebemassen bekannt, zum Beispiel aus der US 4,005,247 A oder der US 3,769,254 A.

Aus der DE 10 2004 031 188 A1 ist ein Klebeband für die Verklebung von elektronischen Bauteilen und flexiblen Leiterbahnen bekannt umfassend eine Klebmasse, bestehend mindestens aus einem säure- oder säureanhydridmodifizierten Vinylaromatenblockcopolymer und einem Epoxidharz.

Metallchelate werden nicht erwähnt.

Die DE 10 2004 007 258 A1 offenbart eine Klebemasse für einen Klebfolienstreifen enthaltend ein Gemisch aus
- einem säure- oder säureanhydridmodifizierten Vinylaromatenblockcopalymer,
- einem Metallchelat der folgenden Formel:

   (R₁O)ₙ M (XR₂Y)ₘ,

   wobei
   M ein Metall der 2., 3., 4. oder 5. Hauptgruppe oder ein Übergangsmetall ist,
   R₁ eine Alkyl- oder Arylgruppe ist;
   n Null oder eine größere ganze Zahl ist,
   X und Y Sauerstoff oder Stickstoff sind, die jeweils auch durch eine Doppelbindung an R2 gebunden sein können;
   R₂ eine X und Y verbindende Alkylengruppe ist, die verzweigt sein kann, oder auch Sauerstoff oder weitere Heteroatome in der Kette enthalten kann;
   m eine ganze Zahl, mindestens jedoch 1 ist,
- sowie einem Klebharz,
wobei sich der Klebfolienstreifen durch dehnendes Verstrecken in Richtung der Klebfuge lösen lässt.

Der Zusatz von epoxidhaltigen Verbindungen wird nicht beschrieben.

Die WO 2007/025007 A1 beschreibt einen Kleber, der sich aus zumindest einem Epoxidharz, aus Kautschukpartikel, aus zumindest einem Weichmacher und zumindest einem hitzeaktivierbaren Härter zusammensetzt.

Die Klebemasse, wie sie in der EP 1 612 251 A1 angegeben ist, enthält neben der Klebemasse aus der DE 10 2004 031 188 A1 zusätzlich noch einen Härter, der bei hohen Temperaturen eine Vernetzung mit den Epoxidgruppen vollführt.

Die EP 1 612 253 A1 beschreibt eine Klebemasse, die aus einem Gemisch von Vinylaromatenblockcopolymer besteht, zum einen ein säure- oder säureanhydridmodifiziertes Vinylaramatenblockcopolymer und zum anderen ein epoxidiertes Vinylaromatenblockcopolymer.

Mit der US 2004/159969 A1 ist ein Lackfilm bekannt geworden, der mit einer druckempfindlichen Kleberschicht ausgerüstet sein kann. Allerdings enthält dieser kein Metallchelat.

Auch die WO 2004/074386 A2 beschreibt einen solchen Lackfilm.

Aufgabe der Erfindung ist es, ein Klebeband bereitzustellen, dass hitzeaktivierbar ist, in der Hitze vernetzt, eine geringe Viskosität in der Hitze besitzt, gute Haftung auf Polyimid zeigt, im unvernetzten Zustand löslich in organischen Lösungsmitteln ist und bei Raumtemperatur einen hohen E-Modul besitzt.

Gelöst wird diese Aufgabe überraschend durch ein Klebeband, wie es in dem Hauptanspruch näher gekennzeichnet ist. Gegenstand der Unteransprüche sind vorteilhafte Weiterentwicklungen des Erfindungsgegenstandes sowie Verwendungsmöglichkeiten desselben.

Demgemäß ist Gegenstand der Erfindung ein hitzeaktivierbares Klebeband insbesondere für die Verklebung von elektronischen Bauteilen und Leiterbahnen mit einer Klebemasse, die zumindest aus
a) einem säure- oder säureanhydridmodifizierten Vinylaromatenblockcopolymer,
b) einer epoxidhaltigen Verbindung und
c) einem Metallchelat
besteht.

Der allgemeine Ausdruck Klebeband umfasst im Sinne dieser Erfindung alle flächigen Gebilde wie in zwei Dimensionen ausgedehnte Folien oder Folienabschnitte, Bänder mit ausgedehnter Länge und begrenzter Breite, Bandabschnitte, Stanzlinge und dergleichen.

Als Klebemassen finden bevorzugt solche auf Basis von Blockcopolymeren enthaltend Polymerblöcke überwiegend gebildet von Vinylaromaten (A-Blöcke), bevorzugt Styrol, und solchen überwiegend gebildet durch Polymerisation von 1,3-Dienen (B-Blöcke), bevorzugt Butadien und Isopren Anwendung. Sowohl Homo- als auch Copolymerblöcke sind erfindungsgemäß nutzbar. Resultierende Blockcopolymere können gleiche oder unterschiedliche B-Blöcke enthalten, die teilweise, selektiv oder vollständig hydriert sein können. Blockcopolymere können lineare A-B-A-Struktur aufweisen. Einsetzbar sind ebenfalls Blockcopolymere von radialer Gestalt sowie sternförmige und lineare Multiblockcopolymere. Als weitere Komponenten können A-B-Zweiblockcopolymere vorhanden sein. Blockcopolymere von Vinylaromaten und Isobutylen sind ebenfalls erfindungsgemäß einsetzbar. Sämtliche der vorgenannten Polymere können alleine oder im Gemisch miteinander genutzt werden.

Zumindest ein Teil der eingesetzten Blockcopolymere muss dabei säure- oder säureanhydridmodifiziert sein, wobei die Modifizierung hauptsächlich durch radikalische Pfropfcopolymerisation von ungesättigten Mono- und Polycarbonsäuren oder -säureanhydriden wie zum Beispiel Fumarsäure, Itaconsäure, Citraconsäure, Acrylsäure, Maleinsäureanhydrid, Itaconsäureanhydrid oder Citraconsäureanhydrid, bevorzugt Maleinsäureanhydrid, erfolgt. Bevorzugt liegt der Anteil an Säure beziehungsweise Säureanhydrid zwischen 0,5 und 4 Gewichtsprozenten bezogen auf das gesamte Blockcopolymer.

Kommerziell sind solche Blockcopolymere zum Beispiel unter dem Namen Kraton^{™} FG 1901 und Kraton^{™} FG 1924 der Firma Shell beziehungsweise Tuftec^{™} M 1913 und Tuftec^{™} M 1943 der Firma Asahi erhältlich.

Als Epoxidharze werden üblicherweise sowohl monomere als auch oligomere Verbindungen mit mehr als einer Epoxidgruppe pro Molekül verstanden. Diese können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze, gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden, sind verwendbar. Ebenfalls sind elastisch modifizierte Epoxidharze einsetzbar oder epoxidmodifizierte Elastomere wie zum Beispiel epoxidierte Styrolblockcopolymere, zum Beispiel Epofriend der Firma Daicel.

Beispiele von Epoxidharzen sind Araldite^{™} 6010, CY-281^{™}, ECN^{™} 1273, ECN^{™} 1280, MY 720, RD-2 von Ciba Geigy, DER^{™} 331, 732, 736, DEN^{™} 432 von Dow Chemicals, Epon^{™} 812, 825, 826, 828, 830 etc. von Shell Chemicals, HPT^{™} 1071, 1079 ebenfalls von Shell Chemicals, Bakelite^{™} EPR 161, 166, 172, 191, 194 etc. der Bakelite AG .

Kommerzielle aliphatische Epoxidharze sind zum Beispiel Vinylcyclohexandioxide wie ERL-4206, 4221, 4201, 4289 oder 0400 von Union Carbide Corp.

Elastifizierte Elastomere sind erhältlich von der Firma Noveon unter dem Namen Hycar.

Epoxidverdünner, monomere Verbindungen mit mehreren Epoxidgruppen sind zum Beispiel Bakelite^{™} EPD KR, EPD Z8, EPD HD, EPD WF, etc. der Bakelite AG oder Polypox^{™} R 9, R12, R 15, R 19, R 20 etc. der Firma UCCP.

Obwohl wie oben beschrieben die Zugabe von Vernetzern nicht nötig ist, können trotzdem weitere Härter zugesetzt werden. Als Härter sollten hier nur Stoffe mit Säure- oder Säureanhydridgruppen eingesetzt werden, da die hauptsächlich für Epoxidvernetzung eingesetzten Amine und Guanidine mit dem Säureanhydrid reagieren und damit die Anzahl der reaktiven Gruppen herabsetzt.

Neben den schon genannten säure- oder säureanhydridmodifizierten Vinylaromatenblockcopolymeren können auch noch weitere Säuren oder Säureanhydride zugesetzt werden, um einen höheren Vernetzungsgrad und damit eine noch weiter verbesserte Kohäsion zu erreichen. Dabei sind sowohl monomere Säureanhydride und Säuren, wie sie in der US 3,970,608 A beschrieben sind, säure- oder säureanhydridmodifizierte Polymere sowie säureanhydridenthaltende Copolymere wie Polyvinylmethylether-maleinsäureanhydrid-Copolymere, zum Beispiel zu beziehen unter dem Namen Gantrez^{™}, vertrieben von der Firma ISP, einsetzbar.

Die Metalle der Metallchelate können die der 2., 3., 4. und 5. Hauptgruppe und die Übergangsmetalle sein. Besonders geeignet sind zum Beispiel Aluminium, Zinn, Titan, Zirkonium, Hafnium, Vanadium, Niob, Chrom, Mangan, Eisen, Kobalt, und Cer. Besonders bevorzugt sind Aluminium und Titan.

Für die Chelatvernetzung können unterschiedliche Metallchelate zum Einsatz kommen, die durch die folgende Formel wiedergegeben werden können:

(R₁O)ₙM(XR₂Y)ₘ,

wobei
M ein Metall wie oben beschrieben ist,
R₁ eine Alkyl- oder Arylgruppe wie Methyl, Ethyl, Butyl, Isopropyl oder Benzyl ist,
n null oder eine größere ganze Zahl ist,
X und Y Sauerstoff oder Stickstoff sind, die jeweils auch durch eine Doppelbindung an R₂ gebunden sein können,
R₂ eine X und Y verbindende Alkylengruppe ist, die verzweigt sein kann, oder auch Sauerstoff oder weitere Heteroatome in der Kette enthalten kann,
m eine ganze Zahl, mindestens jedoch 1 ist.

Bevorzugte Chelatliganden sind solche, die aus der Reaktion folgender Verbindungen entstanden sind: Triethanolamin, 2,4-Pentandion, 2-Ethyl-1,3-Hexandiol oder Milchsäure. Besonders bevorzugte Vernetzer sind Aluminium- und Titanylacetylacetonate.

Dabei sollte ein annähernd äquivalentes Verhältnis zwischen den Säurebeziehungsweise Säureanhydridgruppen und den Acetylacetonatgruppen gewählt werden, um eine optimale Vernetzung zu erreichen, wobei sich ein kleiner Überschuss an Vernetzer als positiv herausgestellt hat.

Das Verhältnis zwischen Anhydridgruppen und Acetylacetonatgruppen kann aber variiert werden, dabei sollte für eine ausreichende Vernetzung keine der beiden Gruppen in mehr als einem fünffachen molaren Überschuss vorliegen.

Durch die chemische Vernetzung der Epoxidharze mit den Elastomeren werden sehr große Festigkeiten innerhalb des Klebefilms erreicht. Aber auch die Verklebungsfestigkeiten zum Polyimid sind ausgesprochen hoch.

Um die Adhäsion zu erhöhen, ist auch der Zusatz von mit dem Elastomerblock der Blockcopolymere verträglichen Klebharzen möglich.

Als Klebrigmacher können in erfindungsgemäßen Haftklebemassen zum Beispiel nicht hydrierte, partiell- oder vollständig hydrierte Harze auf Basis von Kolophonium und Kolophoniumderivaten, hydrierte Polymerisate des Dicyclopentadiens, nicht hydrierte, partiell, selektiv oder vollständig hydrierte Kohlenwasserstoffharze auf Basis von C₅-, C₅/C₉-oder C₉-Monomerströmen, Polyterpenharze auf Basis von α-Pinen und/oder β-Pinen und/oder δ-Limonen, hydrierte Polymerisate von bevorzugt reinen C₈- und C₉-Aromaten eingesetzt werden. Vorgenannte Klebharze können sowohl allein als auch im Gemisch eingesetzt werden.

Als weitere Additive können typischerweise genutzt werden:
- primäre Antioxidanzien wie zum Beispiel sterisch gehinderte Phenole
- sekundäre Antioxidanzien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Endblockverstärkerharze
- Füllstoffe wie zum Beispiel Siliziumdioxid, Glas (gemahlen oder in Form von Kugeln), Aluminiumoxide, Zinkoxide, Calciumcarbonate, Titandioxide, Ruße, Metallpulver, etc.
- Farbpigmente und Farbstoffe sowie optische Aufheller
- gegebenenfalls weitere Polymere von bevorzugt elastomerer Natur.

Vorteilhaft an den erfindungsgemäßen Systemen ist die sehr niedrige Erweichungstemperatur, die sich aus dem Erweichungspunkt des Polystyrols in den Endblöcken der Blockcopolymere ergibt. Da die Elastomere bei der Vernetzungsreaktion mit in ein polymeres Netzwerk eingebunden werden und diese Reaktion bei den hohen Temperaturen von bis zu 200 °C, die üblicherweise für die Verklebung von FPCBs verwendet werden, relativ schnell ist, kommt es nicht zu Austritten der Klebmasse aus der Klebfuge. Durch die Zugabe von so genannten Beschleunigern kann die Reaktionsgeschwindigkeit weiter erhöht werden.

Beschleuniger können zum Beispiel sein:
- tertiäre Amine wie Benzyldimethylamin, Dimethylaminomethylphenol, Tris(dimethylaminomethyl)phenol
- Bortrihalogenid-Amin-Komplexe
- substituierte Imidazole
- Triphenylphosphin

Idealerweise werden die säure- beziehungsweise säureanhydridmodifizierten Elastomere und Epoxidharze in einem Mengenverhältnis eingesetzt, so dass der molare Anteil an Epoxidgruppen und Anhydridgruppen gerade äquivalent ist. Bei der Verwendung von nur gering modifizierten Elastomeren und dem Einsatz niedermolekularer Epoxidharze mit einem niedrigen Epoxidäquivalent ergeben sich dabei nur sehr geringe Mengen - von unter 10 Gew.-% bezogen auf das modifizierte Styrolblockcopolymer - an Epoxidharz, die eingesetzt werden.

Das Verhältnis zwischen Anhydridgruppen und Epoxidgruppen kann aber in weiten Bereichen variiert werden, dabei sollte für eine ausreichende Vernetzung keine der beiden Gruppen in mehr als einem vierfachen molaren Überschuss vorliegen.

Zur Herstellung des Klebebandes werden die Bestandteile der Klebmasse vorteilhaft in einem geeigneten Lösungsmittel, zum Beispiel Toluol oder Mischungen aus Benzin 70/90 und Aceton, gelöst und auf ein flexibles Substrat, das mit einer Releaseschicht versehen ist, zum Beispiel einem Trennpapier oder einer Trennfolie beschichtet und getrocknet, so dass die Masse von dem Substrat leicht wieder entfernt werden kann. Nach entsprechender Konfektionierung können Stanzlinge, Rollen oder sonstige Formkörper bei Raumtemperatur hergestellt werden. Entsprechende Formkörper werden dann vorzugsweise bei erhöhter Temperatur auf das zu verklebende Substrat, zum Beispiel Polyimid, aufgeklebt.

Es ist auch möglich, die Klebmasse direkt auf einen Polyimidträger zu beschichten. Solche Klebfolien können dann zur Abdeckung von Kupferleiterbahnen für FPCBs eingesetzt werden.

Es ist nicht erforderlich, dass die Verklebung als einstufiges Verfahren erfolgt. Vielmehr kann auf eines der beiden Substrate zunächst das Klebeband geheftet werden, indem man in der Wärme laminiert. Beim eigentlichen Heißklebeprozess mit dem zweiten Substrat (zweite Polyimidfolie oder Kupferfolie) härtet das Harz dann ganz oder teilweise aus, und die Klebstofffuge erreicht die hohe Verklebungsfestigkeit.

Die zugemischten Epoxidharze sollten vorzugsweise bei der Laminiertemperatur noch keine chemische Reaktion eingehen, sondern erst bei der Heißverklebung mit den Säure-oder Säureanhydridgruppen reagieren.

Vorteil der erfindungsgemäßen Klebemasse ist, dass das Elastomer tatsächlich chemisch mit dem Harz vernetzt, eine Zugabe eines Härters für das Epoxidharz ist nicht zwingend notwendig, da das Elastomer selbst als Härter wirkt.

Durch die Vernetzung mit den Metallchelaten, die während der Trocknung bei der Herstellung auftritt, werden die erfindungsgemäßen Klebmassen deutlich versteift, beziehungsweise das E-Modul wird erhöht.

Überraschenderweise kommt es trotz dieser Vernetzung bei Raumtemperatur zwischen den Säure- beziehungsweise Säureanhydridgruppen der Elastomere und der Metallchelate durch die Aktivierung mit Hitze, meistens bei Temperaturen von über 150 °C zu einer Vernetzung der modifizierten Elastomere und der Epoxidharze, wodurch eine hohe Kohäsion und eine hohe Verklebungsfestigkeit erreicht wird. Die Metallchelate stören diesen zweiten Vernetzungsschritt nicht.

### Beispiele

Im Folgenden wird die Erfindung durch einige Beispiele näher beschrieben, ohne dabei die Erfindung in irgendeiner Weise zu beschränken.

### Beispiel 1

Eine Mischung aus 92,5 g Kraton^{™} FG 1901 (maleinsäureanhydridmodifiziertes Styrol-Ethylenbutylen-Styrol-Blockcopolymer mit 30 Gew.-% Blockpolystyrol und ca. 2 Gew.-% Maleinsäureanhydrid), 7,5 g Bakelite^{™} EPR 191 (Epoxidharz) und 2 g Aluminiumacetylacetonat werden in Toluol gelöst und aus Lösung auf ein mit 1,5 g/m³ silikonisiertes Trennpapier beschichtet und bei 110 °C für 15 min getrocknet. Die Dicke der Klebeschicht beträgt 25 µm.

### Beispiel 2

Eine Mischung aus 87,4 g Kraton^{™} FG 1901, 2,6 g Bakelite^{™} EPR 161 (Epoxidharz), 10 g Regalite^{™} R 1100 (hydriertes Kohlenwasserstoffharz mit einem Erweichungspunkt von ca. 100 °C der Firma Eastman) und 1,5 g Aluminiumacetylacetonat werden in Toluol gelöst und aus Lösung auf ein mit 1,5 g/m³ silikonisiertes Trennpapier beschichtet und bei 110 °C für 15 min getrocknet. Die Dicke der Klebeschicht beträgt 25 µm.

### Vergleichsbeispiel 3

Eine Mischung aus 92,5 g Kraton^{™} FG 1901 (maleinsäureanhydridmodifiziertes Styrol-Ethylenbutylen-Styrol-Blockcopolymer mit 30 Gew.-% Blockpolystyrol und ca. 2 Gew.-% Maleinsäureanhydrid) und 7,5 g Bakelite^{™} EPR 191 (Epoxidharz) werden in Toluol gelöst und aus Lösung auf ein mit 1,5 g/m³ silikonisiertes Trennpapier beschichtet und bei 110 °C für 15 min getrocknet. Die Dicke der Klebeschicht beträgt 25 µm.

### Verklebung von FPCBs mit dem hergestellten Klebeband

Zwei FPCBs wurden jeweils mit den nach den Beispielen 1 bis 3 hergestellten Klebebändern verklebt. Dazu wurde das Klebeband auf die Polyimidfolie des FPCB-Laminats aus Polyimid/Kupferfolie bei 100 °C auflaminiert. Anschließend wurde eine zweite Polyimidfolie eines weiteren FPCBs auf das Klebeband geklebt, und der ganze Verbund in einer beheizbaren Bürklepresse bei 180 °C bei einem Druck von 1,3 MPa für 30 min verpresst.

### Prüfmethoden

Die Eigenschaften der nach den oben genannten Beispielen hergestellten Klebstofffolien wurden mit folgenden Testmethoden untersucht.

### T-Peel Test mit FPCB

Mit einer Zugprüfmaschine der Firma Zwick wurden die nach dem oben beschriebenen Verfahren hergestellten Verbunde aus FPCB/Klebeband/FPCB im 180° Winkel mit einer Geschwindigkeit von 50 mm/min auseinander gezogen und die benötigte Kraft in N/cm gemessen. Die Messungen wurden bei 20 °C und 50% rel. Feuchte durchgeführt. Jeder Messwert wurde dreifach bestimmt.

### Kraft bei 5 %-Dehnung

Da es bei solch dünnen sehr flexiblen Materialien häufig schwierig ist, den E-Modul zu bestimmen, wurde stattdessen eine Kraft bei 5 %-Dehnung gemessen. Dazu wurde aus der Klebmasse ein 1 cm breiter und 10 cm langer Klebestreifen ausgestanzt, der in eine Zugprüfmaschine eingespannt wurde. Der Streifen wurde nun mit einer Geschwindigkeit von 300 mm/min gedehnt und die Kraft bei einer Dehnung von 5 % aufgenommen. Der Wert wird in N/cm angegeben.

### Lötbadbeständigkeit

Die nach dem oben beschriebenen Verfahren verklebten FPCB-Verbunde wurden für 10 Sekunden auf ein 288 °C heißes Lötbad gelegt. Die Verklebung wurde als lötbadbeständig gewertet, wenn sich keine Luftblasen bildeten, welche die Polyimidfolie des FPCBs aufblähen ließen. Der Test wurde als nicht bestanden gewertet, wenn bereits eine leichte Blasenbildung eintrat.

### Temperaturbeständigkeit

Analog zum beschriebenen T-Peel-Test wurde eine Seite der nach dem oben offenbarten Verfahren hergestellten FPCB-Verbunde aufgehängt, an der anderen Seite wurde ein Gewicht von 500g befestigt. Der statische Schältest fand bei 70 °C statt. Gemessen wurde der statische Schälweg in mm/h.

### Ergebnisse:

Zur klebtechnischen Beurteilung der obengenanten Beispiele wurde zunächst der T-Peel Test durchgeführt.

Die Ergebnisse sind Tabelle 1 zu entnehmen.

**Tabelle 1**

| | T-Peel Test [N/cm] |
|---|---|
| Beispiel 1 | 8,6 |
| Beispiel 2 | 14,8 |
| Beispiel 3 | 9,7 |

Wie zu erkennen ist, konnten in den Beispielen 1 und 3 ähnlich hohe Klebkräfte erreicht werden.

Die Temperaturbeständigkeit der Klebebänder wurde mit dem statischen Peel-Test gemessen, dessen Werte in Tabelle 2 zu finden sind.

**Tabelle 2**

| | Statischer T-Peel Test bei 70 °C [mm/h] |
|---|---|
| Beispiel 1 | 4 |
| Beispiel 2 | 11 |
| Beispiel 3 | 5 |

Auch hier gibt es keine großen Unterschiede zwischen den Beispielen 1 und 3, nur das harzabgemischte Produkt, Beispiel 2, zeigt eine etwas größere Schälung.

Die Kraft bei 5 %-Dehnung kann der Tabelle 3 entnommen werden

**Tabelle 3**

| | Kraft bei 5 %-Dehnung [N/cm] |
|---|---|
| Beispiel 1 | 1,4 |
| Beispiel 2 | 1,2 |
| Beispiel 3 | 0,6 |

Durch die Vernetzung mit den Chelaten ist die Kraft, die zur Verdehnung der Klebestreifen benötigt wird deutlich angehoben.

Der Lötbadtest wurde von allen drei Beispielen bestanden.

## Patentansprüche

1. Hitzeaktivierbares Klebeband insbesondere für die Verklebung von elektronischen Bauteilen und Leiterbahnen mit einer Klebemasse, die zumindest aus
a) einem säure- oder säureanhydridmodifizierten Vinylaromatenblockcopolymer,
b) einer epoxidhaltigen Verbindung und
c) einem Metallchelat
besteht.

2. Hitzeaktivierbares Klebeband nach Anspruch 1, **dadurch gekennzeichnet, dass** es sich bei dem Vinylaromatenblockcopolymer um ein Styrolblockcopolymer handelt.

3. Hitzeaktivierbares Klebeband nach Anspruch 1 oder 2, **dadurch gekennzeichnet, dass** die epoxidhaltige Verbindung ein Epoxidharz und/oder ein epoxidiertes Polymer ist.

4. Hitzeaktivierbares Klebeband nach zumindest einem der Ansprüche 1 bis 3, **dadurch gekennzeichnet, dass** die Epoxidgruppen mit den Säure- beziehungsweise Säureanhydridgruppen der Elastomere bei Temperaturen über 150°C vernetzen.

5. Hitzeaktivierbares Klebeband nach zumindest einem der vorigen Ansprüche, **dadurch gekennzeichnet, dass** die Metallchelate beschrieben werden können mit der Formel
(R₁O)ₙ M (XR₂Y)ₘ,
wobei
M ein Metall der 2., 3., 4. oder 5. Hauptgruppe oder ein Übergangsmetall ist,
R₁ eine Alkyl- oder Arylgruppe wie Methyl, Ethyl, Butyl, Isopropyl oder Benzyl ist,
n null oder eine größere ganze Zahl ist,
X und Y Sauerstoff oder Stickstoff sind, die jeweils auch durch eine Doppelbindung an R₂ gebunden sein können,
R₂ eine X und Y verbindende Alkylengruppe ist, die verzweigt sein kann, oder auch Sauerstoff oder weitere Heteroatome in der Kette enthalten kann,
m eine ganze Zahl, mindestens jedoch 1 ist.

6. Hitzeaktivierbares Klebeband nach zumindest einem der vorigen Ansprüche, **dadurch gekennzeichnet, dass** es sich bei dem Metallchelat um Aluminium- oder Titanylacetylacetonat handelt.

7. Hitzeaktivierbares Klebeband nach zumindest einem der vorigen Ansprüche, **dadurch gekennzeichnet, dass** das Klebeband weitere Säureanhydride, weitere Elastomere, klebrigmachende Harze, Beschleuniger, Farbstoffe, Ruß und/oder Metallpulver enthält.

8. Hitzeaktivierbares Klebeband nach zumindest einem der vorigen Ansprüche, **dadurch gekennzeichnet, dass** der Anteil der Epoxidharze höchstens 10 Gew.-%, bevorzugt 5 Gew.-% bezogen auf den Anteil an säure- beziehungsweise säureanhydridmodifiziertem Elastomer beträgt.

9. Verfahren zur Verklebung von Kunststoffteilen, bei dem das hitzeaktivierbare Klebeband nach zumindest einem der vorherigen Ansprüche zumindest bestehend aus einem säure- oder säureanhydridmodifiziertem Vinylaromatenblockcopolymer und einem Epoxidharz eingesetzt wird.

10. Verwendung eines hitzeaktivierbaren Klebebands nach zumindest einem der vorigen Ansprüche zur Verklebung von Kunststoffteilen.

11. Verwendung eines hitzeaktivierbaren Klebebands nach zumindest einem der vorigen Ansprüche zur Verklebung von elektronischen Bauteilen und/oder von flexiblen gedruckten Schaltungen (FPCBs).

12. Verwendung eines hitzeaktivierbaren Klebebands nach zumindest einem der vorigen Ansprüche zur Verklebung auf Polyimid.

## Claims

1. Heat-activable adhesive tape particularly for bonding electronic components and conductor tracks, with an adhesive composed at least of
a) an acid-modified or acid anhydride-modified vinylaromatic block copolymer,
b) an epoxide-containing compound and,
c) a metal chelate.

2. Heat-activable adhesive tape according to Claim 1, **characterized in that** the vinylaromatic block copolymer is a styrene block copolymer.

3. Heat-activable adhesive tape according to Claim 1 or 2, **characterized in that** the epoxide-containing compound is an epoxy resin and/or an epoxidized polymer.

4. Heat-activable adhesive tape according to at least one of Claims 1 to 3, **characterized in that** the epoxide groups crosslink with the acid and/or acid anhydride groups of the elastomers at temperatures above 150°C.

5. Heat-activable adhesive tape according to at least one of the preceding claims, **characterized in that** the metal chelates can be described by the formula
(R₁O)ₙ M (XR₂Y)ₘ,
where
M is a metal from main group 2, 3, 4 or 5, or a transition metal,
R1 is an alkyl or aryl group such as methyl, ethyl, butyl, isopropyl or benzyl,
n is zero or a larger integer,
X and Y are oxygen or nitrogen, which in each case may also be attached to R2 by a double bond,
R2 is an alkylene group which connects X and Y and which may be branched, or else may contain oxygen or further heteroatoms in the chain,
m is an integer, but is at least 1.

6. Heat-activable adhesive tape according to at least one of the preceding claims, **characterized in that** the metal chelate is aluminium acetylacetonate or titanyl acetylacetonate.

7. Heat-activable adhesive tape according to at least one of the preceding claims, **characterized in that** the adhesive tape comprises further acid anhydrides, further elastomers, tackifying resins, accelerators, dyes, carbon black and/or metal powders.

8. Heat-activable adhesive tape according to at least one of the preceding claims, **characterized in that** the fraction of the epoxy resins is not more than 10% by weight, preferably 5% by weight, based on the fraction of acid-modified and/or acid anhydride-modified elastomer.

9. Method of adhesively bonding plastic parts, wherein the heat-activable adhesive tape according to at least one of the preceding claims, at least consisting of an acid-modified or acid anhydride-modified vinylaromatic block copolymer and an epoxy resin, is used.

10. Use of a heat-activable adhesive tape according to at least one of the preceding claims for bonding plastic parts.

11. Use of a heat-activable adhesive tape according to at least one of the preceding claims for bonding electronic components and/or flexible printed circuits (FPCBs).

12. Use of a heat-activable adhesive tape according to at least one of the preceding claims for bonding to polyimide.

## Revendications

1. Ruban adhésif thermoactivable, notamment pour le collage de composants électroniques et de pistes conductrices avec une masse adhésive, consistant au moins dans
a) un copolymère bloc vinylaromatique modifié par acide ou par anhydride d'acide,
b) un composé contenant des époxydes
c) un chélate métallique.

2. Ruban adhésif thermoactivable selon la revendication 1, **caractérisé en ce que** le polymère bloc vinylaromatique est un copolymère bloc de styrène.

3. Ruban adhésif thermoactivable, selon la revendication 1 ou 2, **caractérisé en ce que** le composé contenant des époxydes est une résine époxy et/ou un polymère époxydé.

4. Ruban adhésif thermoactivable selon au moins l'une quelconque des revendications 1 à 3, **caractérisé en ce que** les groupes époxyde se réticulent avec les groupes acide ou les groupes anhydride d'acide des élastomères à des températures supérieures à 150°C.

5. Ruban adhésif thermoactivable selon au moins l'une quelconque des revendications précédentes, **caractérisé en ce que** les chélates métalliques peuvent être décrits par la formule
(R₁O)ₙM(XR₂Y)ₘ,
dans laquelle
M est un métal du 2^{ème}, 3^{ème}, 4^{ème} ou 5^{ème} groupe principal ou un métal transitoire,
R₁ est un groupe alkyle, ou un groupe aryle, comme le méthyle, l'éthyle, le butyle, l'isopropyle ou le benzyle,
n est zéro ou un nombre entier plus élevé,
X et Y sont l'oxygène ou l'azote, qui peuvent chacun être également liés à R₂ par une liaison double,
R₂ est un groupe alkyle reliant X et Y, qui peut être ramifié ou qui peut également contenir l'oxygène ou d'autres hétéroatomes dans la chaîne,
m est un nombre entier, mais au minimum 1.

6. Ruban adhésif thermoactivable selon au moins l'une quelconque des revendications précédentes, **caractérisé en ce que** le chélate métallique est de l'acétylacétonate d'aluminium ou du titanyle acétylacétonate.

7. Ruban adhésif thermoactivable selon au moins l'une quelconque des revendications précédentes, **caractérisé en ce que** le ruban adhésif contient d'autres anhydrides d'acide, d'autres élastomères, des résines gluantes, des accélérateurs, des colorants, du noir de carbone et/ou de la poudre métallique.

8. Ruban adhésif thermoactivable selon au moins l'une quelconque des revendications précédentes, **caractérisé en ce que** la part des résines époxy s'élève au maximum à 10% en poids, de préférence à 5% en poids en rapport à la part d'élastomère modifié par acide ou par anhydride d'acide.

9. Procédé de collage d'éléments en matière plastique dans lequel le ruban adhésif thermoactivable est mis en oeuvre selon au moins l'une quelconque des revendications précédentes, consistant au moins dans un copolymère bloc vinylaromatique modifié par acide ou par anhydride d'acide et dans une résine époxy.

10. Utilisation d'un ruban adhésif thermoactivable selon au moins l'une quelconque des revendications précédentes pour le collage d'éléments en matière plastique.

11. Utilisation d'un ruban adhésif thermoactivable selon au moins l'une quelconque des revendications précédentes pour le collage de composants électroniques et/ou de circuits imprimés flexibles (FPCB).

12. Utilisation d'un ruban adhésif thermoactivable selon au moins l'une quelconque des revendications précédentes pour le collage sur du polyimide.
